# EUROPEAN PATENT SPECIFICATION

(11) **EP 0 787 992 B1**
(45) Date of publication and mention of the grant of the patent: **28.03.2001**
(21) Application number: 97400184.4
(22) Date of filing: 27.01.1997
(51) Int. Cl.: G01R 11/04

(54) **Housing for an electricity meter**
Gehäuse für Elektrizitätsmeter
Boîtier pour compteur électrique

(30) Priority: 30.01.1996 DE 29601526 U
(43) Date of publication of application: 06.08.1997
(73) Proprietor: AEG Zähler GmbH, 31785 Hameln (DE)
(72) Inventor: Hüskes, Rudi, 31020 Salzhemmendorf (DE)
(74) Representative: Hawkes, David John

(56) References cited:
- CH-A- 684 215
- DE-U- 9 414 262

## Description

This invention relates to a housing for an electronic electricity meter comprising a box-shaped base, in which are arranged various circuit modules of the electricity meter, in particular one or more printed circuit boards having circuit components and display elements together with a name plate, the printed circuit board or boards and the name plate being arranged vertically with respect to each other in two or more horizontal planes and retained by latching means.

Electricity meters with printed circuit boards retained within the housing by means of elastic flexible latching or snap-action hooks are known in the art. This type of meter construction has the advantage of being very easy to assemble rapidly. However, there exists the danger that the latching or snap-action hooks, in particular where longer lever arms are employed, can spring outwards or become twisted, as a result of which the printed circuits come loose. Consequently, arrangements of this kind are often sensitive to mechanical shocks.

The patent CH 684215 describes a housing for an electronic electricity meter comprising a box-shaped base in which are arranged one or more circuit boards with circuit components and display elements and a name plate. The circuit boards are pulled on support elements having a pyramidal shape, i.e. with a base larger to the extremity and then latched by latching elements and therefore securing the circuit boards.
The invention proposes an alternative device using the name plate for securing the latching elements. This invention has the objective of providing a housing of the kind referred to above in such a form that the printed circuit boards, or at least those printed circuit boards in the upper plane, can be easily assembled and retained and securely fixed against mechanical shock, whilst at same enabling the centering of the name plate with respect to the meter display elements on the uppermost printed circuit board with low overall manufacturing costs.

This problem is solved by a housing having the characteristics of claim 1. Further embodiments and advantageous forms of the invention are stated in the sub-claims.

This invention has the advantage that the printed circuit board or boards of the first plane, mounted on relatively high supports and pre-centered by appropriately long and elastically flexible latching hooks, can be permanently secured in a vibration resistant manner. At the same time, retention according to the invention is achieved practically without additional components, in that the name plate takes over the function of securing the printed circuit boards. Furthermore, the name plate can be centered without problems and can be easily aligned with liquid crystal displays or drum registers provided on the printed circuit board or boards, as well as being latched with a simple manual operation.

A description of one embodiment of the invention, by way of example only, now follows with reference to the accompanying drawings, in which :
Fig. 1 shows the housing of an electronic electricity meter in a simplified section, and
Fig. 2 represents a detail of item "II" of Fig. 1 on a larger scale.

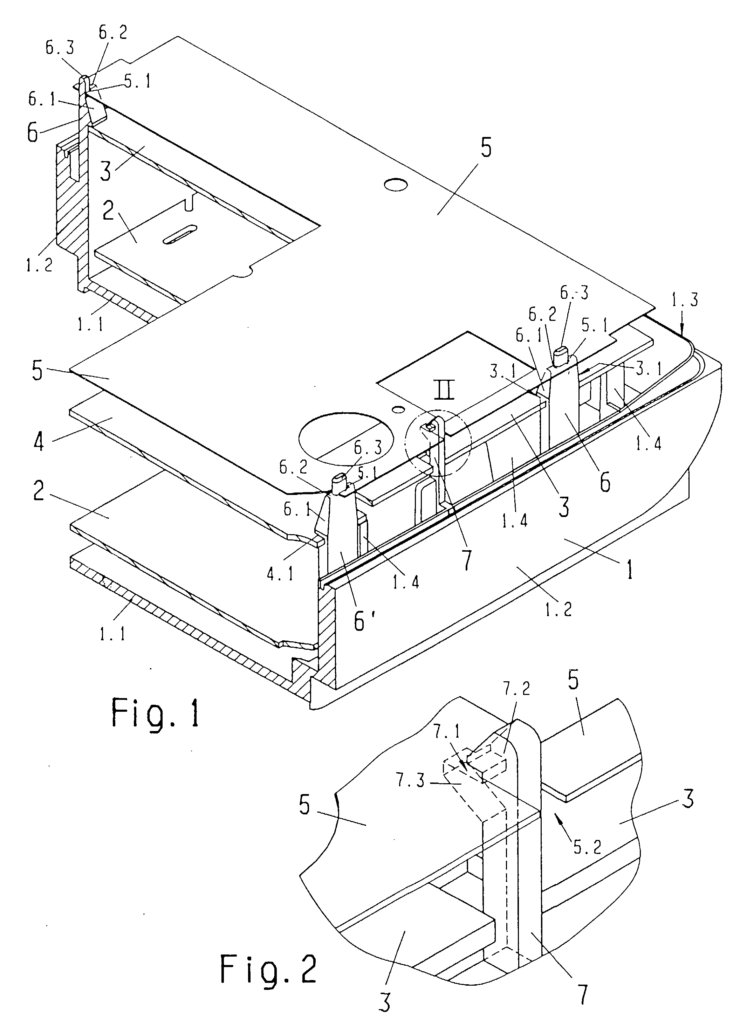

The electricity meter housing only partly shown in Fig. 1 comprises a box-shaped meter base 1 which accepts an electronic measuring arrangement and which is closed by means of a cover (not shown). The meter base 1 comprises a nearly flat rear plate1.1. and surrounding side plates 1.2 and front plates 1.3.

Within the base 1, printed circuit boards 2, 3, 4 of the electricity meter are retained together with circuit components (not shown) and a name plate 5, the circuit boards and name plate being arranged respectively in planes above each other and securely retained. Whereas the printed circuit board 2 in the lower plane fits into fixing devices of the base plate directly via rear plate 1 and retained by means not shown, the printed circuit boards 3, 4 which lie above printed circuit board 2 are mounted on different shaped supporting domes 1.4. The circuit boards 3, 4 are displaced horizontally and, to a small degree, vertically with respect to each other. The supporting domes 1.4 are formed on base plate 1 in an accurate maner in available positional relationships, and project beyond side walls 1.2.

Two latching elements or hooks 6 are arranged approximately opposite each other engaging the circuit board 3, which extends from supporting dome to supporting dome, said latching elements being formed free-standing within base plate 1 on side plates 1.2 in a sufficiently elastic form so as to be capable of spring-type movement. The same applies to the other printed circuit board 4 in the upper plane, of which however only one latching element 6' is shown. Each latching element is provided with a peg 6.1 which engages from the outside over the edge of the associated printed circuit board, approximately in the center. The latching elements 6, 6' thus take over, by means of their latching pegs, the centering of the printed circuit boards as well as the locking function. For this purpose, the printed circuits boards have sideways cutouts 3.1, 4.1, which match the cross section of the latching elements, and the latching elements themselves are appreciably tapered upwards in the contact plane of the support domes 1.4. In this way, both printed circuit boards 3, 4 can be purposely latched from above into their respective end positions on the supporting domes 1.4 by means of the sideways sprung latching hooks 6, 6'.

The four latching hooks 6, 6' also provide, above their wedge-shaped pegs 6.1 extended support areas 6.2 for the metallic name plate 5 terminated in a pivot-shaped projections 6.3. These pass through matching cutouts 5.1 in the name plate 5, whose pattern corresponds exactly with the position of the latching elements for the inserted printed circuits boards 3, 4. In this manner, the name plate, after mounting on the projections 6.3, forms a top plane and secures the latching elements 6, 6' against sideways movements (for example in the event of mechanical shock) and thereby also ensures firm retention of the printed circuit boards.

In order to retain the relatively thin and low-mass name plate 5, which is however of large area, each side plate 1.2 has formed on it, between latching hooks 6, 6' a flexible snap hook 7 on base plate 1, as shown in a larger scale in Figure 2. The snap hook has a slit 7.1 matching the thickness of the name plate 5 and, above this, a sloping retention catch 7.2. Below this, a contact area 7.3 is formed at substantially the height of the support areas 6.2 of the adjacent latching elements. The flat but elastically flexible name plate is provided in the region of the snap hooks with matching sideways apertures or cutouts 5.2, and can therefore be centered by the retaining catches 7.2 with its cutouts 5.1 in correct position above extension 6.3. The name plate is then finally latched in the snap hooks 7 below their catches 7.2 by slight pressure in the region of snap hooks 7 under their catches 7.2. Here, the support areas 7.3 prevent the name plate from being bent too far in spite of manual pressure, the name plate then being locked into slit 7.1. However, the support areas 7.3 are preferably arranged to be slightly lower with respect to supports 6.2, in order to achieve an intentional tensioning of the name plate with a visually perfect appearance.

By this means, all components parts can be locked on to the base plate with the simplest of means, reliably and at low cost.

## Claims

1. Housing for an electronic electricity meter, such housing having a box-shaped horizontal base (1) in which are arranged one or more circuit boards (2, 3, 4) with circuit components and display elements and a name plate (5), the printed circuit board or boards and name plate being arranged vertically with respect to each other in two or more horizontal planes and retained by latching means, the uppermost printed circuit board or boards (3, 4) are retained on a plurality of supports (1.4) by means of elastically resilient latching elements (6, 6') formed on the meter base (1), characterised in that each latching element (6, 6') is provided with a projection (6.3) on its upper face, on which the name plate (5) is placed as the uppermost plane, thereby securing the printed circuit board or boards, the name plate being provided with a plurality of apertures (5. 1) whose pattern corresponds to the positions of the projections (6.3) after the printed circuit board or boards have been latched in place.

2. A housing as claimed in claim 1, characterised in that upper face of the latching elements forms a support area (6.2) for the name plate (5).

3. A housing as claimed in claim 1 or 2, characterised in that the name plate (5) is lockable by means of further snap hooks (7), which each have an additional support area (7.3) in the plane of the support areas (6.2) formed on the latching elements.

4. A housing as claimed in claim 3, characterised in that the snap hooks (7) are provided with a slit (7.1) corresponding to the thickness of the name plate (5), the lower slit plane forming the support area (7.3).

## Patentansprüche

1. Gehäuse für einen elektronischen Stromzähler, mit einem kastenförmigen, flach liegenden Basisteil (1), in dem eine oder mehr Leiterplatten (2, 3, 4) mit Schaltungskomponenten und Anzeigeelementen und einer Typenplatte (5) angeordnet sind, wobei die Leiterplatte oder die Leiterplatten und die Typenplatte übereinander liegend in zwei oder mehreren waagrechten Ebenen angeordnet sind und durch Rastmittel gehalten werden, wobei die oberste Leiterplatte oder die obersten Leiterplatten (3, 4) auf einer Vielzahl von Stützen (1.4) durch elastisch nachgiebige Rastelemente (6, 6'), die an dem Basisteil (1) des Zählers gestaltet sind, gehalten werden, dadurch gekennzeichnet, daß jedes Rastelement (6, 6') an seiner oberen Fläche mit einem Überstand (6.3) versehen ist, auf den die Typenplatte (5) als oberste Ebene gesetzt wird, und wodurch die Leiterplatte oder die Leiterplatten gesichert werden, wobei die Typenplatte mit einer Vielzahl von Öffnungen (5.1) versehen ist, deren Anordnung den Positionen der Überstände (6.3) entspricht, nachdem die Leiterplatte oder die Leiterplatten an ihrem Platz verrastet sind.

2. Gehäuse nach Anspruch 1, dadurch gekennzeichnet, daß die obere Fläche der Rastelemente einen Auflagebereich (6.2) für die Typenplatte (5) bildet.

3. Gehäuse nach Anspruch 1 oder 2, dadurch gekennzeichnet, daß die Typenplatte (5) durch Schnapphaken (7) verrastbar ist, von denen jeder einen zusätzlichen Auflagebereich (7.3) in der Höhe der Auflagebereiche (6.2) hat, die an den Rastelementen gebildet sind.

4. Gehäuse nach Anspruch 3, dadurch gekennzeichnet, daß die Schnapphaken (7) mit einem Schlitz (7.1) versehen sind, der der Dicke der Typenplatte (5) entspricht, wobei die untere Schlitzebene den Auflagebereich (7.3) bildet.

## Revendications

1. Boîtier pour compteur d'électricité électronique, ce boîtier ayant un socle (1) horizontal en forme de boîte dans lequel sont logées une ou plusieurs cartes de circuits (2, 3, 4) comportant des composants de circuits et des éléments d'affichage ainsi qu'une plaque (5) portant des inscriptions, la carte ou les cartes de circuits imprimés et la plaque portant des inscriptions étant agencées verticalement l'une par rapport à l'autre dans deux ou plusieurs plans horizontaux et étant retenues par des moyens de verrouillage, la carte ou les cartes de circuits imprimés les plus hautes (3, 4) étant retenue sur une pluralité de supports (1.4) au moyen d'éléments de verrouillage élastiquement résilients (6, 6') formés sur le socle (1) du compteur, caractérisé en ce que chaque élément de verrouillage (6, 6') est muni d'une protubérance (6.3) sur sa face supérieure, sur laquelle la plaque portant des inscriptions (5) est placée en tant que plan le plus haut, ce qui permet de fixer la carte ou les cartes de circuits imprimés, la plaque portant des inscriptions étant munie d'une pluralité d'ouvertures (5.1) dont l'agencement correspond aux positions des protubérances (6.3) après que la carte ou les cartes de circuits imprimés aient été verrouillées en place.

2. Boîtier selon la revendication 1, caractérisé en ce que la face supérieure des éléments de verrouillage forme une zone de support (6.2) pour la plaque portant des inscriptions (5).

3. Boîtier selon la revendication 1 ou 2, caractérisé en ce que la plaque portant des inscriptions (5) est verrouillable au moyen de crochets encliquetables supplémentaires (7), qui ont chacun une zone de support supplémentaire (7.3) dans le plan des zones de support (6.2) formées sur les éléments de verrouillage.

4. Boîtier selon la revendication 3, caractérisé en ce que les crochets encliquetables (7) sont munis d'une fente (7.1) correspondant à l'épaisseur de la plaque portant des inscriptions (5), le plan des fentes inférieures formant la zone de support (7.3).
